# EUROPÄISCHE PATENTANMELDUNG

(11) **EP 1 351 560 A2**
(43) Veröffentlichungstag der Anmeldung: **08.10.2003**
(21) Anmeldenummer: 03006023.0
(22) Anmeldetag: 27.03.2003
(51) Int. Cl.: H05K 5/00, H05K 5/06

(54) **Verfahren zur Herstellung eines elektronischen Geräts und elektronisches Gerät**

(30) Priorität: 28.03.2002 DE 10214308; 10.02.2003 DE 10305364
(71) Anmelder: SIEMENS AKTIENGESELLSCHAFT, 80333 München (DE)
(72) Erfinder: Jaklin, Ralf, 65835 Liederbach (DE); Wallrafen, Werner, 65719 Hofheim (DE)

(57) **Zusammenfassung**

Gegenstand der Erfindung ist ein Verfahren zur Herstellung eines elektronischen Geräts, wobei ein mit elektronischen Bauteilen bestücktes Stanzblechteil mit einem thermoplastischen, isolierenden Material zum Schutz vor Umwelteinflüssen umspritzt wird sowie ein elektronisches Gerät bestehend aus auf einem Stanzblechteil angeordneten und durch dieses elektrisch miteinander verbundenen elektronischen Bauteilen, wobei das Stanzblechteil und die elektronischen Bauteile im Spritzgussverfahren mit einem thermoplastischen, isolierenden Material umspritzt sind.

Um eine Vorrichtung anzugeben, bei welcher der Schutz der elektronischen Bauteile während des Umspritzens gewährleistet ist, weist das Stanzblechteil (2) mindestens einen schutzschildartigen Bereich (3) auf, unter welchem die elektronischen Bauteile angeordnet sind und die elektronischen Bauteile (4) sind in Spritzdruckrichtung (9) des erwärmten, thermoplastischen, isolierenden Materials (5) hinter dem Stanzblechteil (2) angeordnet.

## Beschreibung

Die Erfindung betrifft ein Verfahren zur Herstellung eines elektronischen Geräts, wobei ein mit elektronischen Bauteilen bestücktes Stanzblechteil mit einem thermoplastischen, isolierenden Material zum Schutz vor Umwelteinflüssen umspritzt wird sowie ein elektronisches Gerät bestehend aus auf einem Stanzblechteil angeordneten und durch dieses elektrisch miteinander verbundenen elektronischen Bauteilen, wobei das Stanzblechteil und die elektronischen Bauteile im Spritzgussverfahren mit einem thermoplastischen, isolierenden Material umspritzt sind.

Zum Schutz vor Umgebungseinflüssen werden elektronische Schaltungen üblicherweise vollständig mit Kunststoff ummantelt. Ein Verfahren zur Umspritzung elektronischer Schaltungen mit isolierendem Material ist aus der deutschen Offenlegungsschrift DE 44 36 523 A1 bekannt. Hier wird ein Leiterteil vor dem Bestücken mit elektronischen Bauteilen derart mit einem elektrisch isolierenden Material umspritzt, dass zur Positionierung und Verbindung der elektronischen Bauteile in der Umspritzung auf dem Leiterteil Aussparungen verbleiben. Anschießend erfolgt die Bestückung mit elektronischen Bauteilen und ihre Verschweißung. Danach setzt man das teilweise umspritzte Leiterteil in eine Spritzgießform zum Umspritzen mit einem ein Gehäuse eines elektronischen Gerätes bildenden Material ein.

Ein derartig hergestelltes elektronisches Gerät findet seinen Einsatz zum Beispiel als im Kraftfahrzeug betriebener Sensor.

In Kraftfahrzeugen eingesetzte Sensoren sind sehr widrigen Umweltbedingungen ausgesetzt. ABS-Sensoren zum Beispiel müssen starke Verschmutzungen vertragen, erheblichen Temperaturschwankungen standhalten, dabei äußerst zuverlässig arbeiten und sehr langlebig sein. Dies kann nur gewährleistet werden, wenn der Sensor und die in seiner unmittelbaren Nähe erforderliche Elektronik mit mindestens einer hochwertigen Schutzschicht ummantelt ist.

Es hat sich als kostengünstig und verfahrenstechnisch vorteilhaft erwiesen, den Sensor und die in seiner unmittelbaren Nähe erforderliche Elektronik vollständig an einem Stanzblechteil zu montieren. Das metallische Stanzblechteil wird dabei sowohl zur elektrischen Kontaktierung der elektronischen Bauteile, als auch zur mechanischen Fixierung der Bauteile in der gewünschten Position verwendet. Die elektronischen Bauteile werden durch Verlöten oder Verschweißen mit dem Stanzblechteil mechanisch und elektrisch verbunden. Die so vorbereitete Baugruppe wird in ein vorgefertigtes Gehäuseunterteil eingesetzt und dann in eine Spritzgussform zur Herstellung der oberen Gehäusehälfte eingelegt. Die obere Gehäusehälfte entsteht durch das Verspritzen des elektrisch isolierenden Materials.

Beim Umspritzen der elektronischen Bauteile wird auf diese ein sehr hoher Spritzdruck übertragen und sie werden mit einer hohen Temperatur beaufschlagt, die von dem erwärmt verspritzen, isolierenden Material an die Bauteile abgegeben wird, was zur Beschädigung oder Zerstörung einzelner elektronischer Bauteile führen kann, wodurch die gesamte Baugruppe wertlos wird.

Der Erfindung liegt daher die Aufgabe zugrunde, ein Verfahren und eine Vorrichtung anzugeben, bei welchen der Schutz der elektronischen Bauteile während des Umspritzens gewährleistet ist.

Die Aufgabe wird erfindungsgemäß dadurch gelöst, dass das erwärmte, thermoplastische, isolierende Material so verspritzt wird, dass es zunächst das Stanzblechteil erreicht, wodurch dort ein wesentlicher Teil seiner thermischen und kinetischen Energie deponiert wird und es anschließend die elektronischen Bauteile umfließt.

Dieses Verfahren hat den Vorteil, dass das erwärmt verspritzte, isolierende Material den größten Teil seiner kinetischen und thermischen Energie auf das robuste Stanzblechteil überträgt, ohne dass die empfindlichen elektronischen Bauteile direkt getroffen werden, wodurch deren Beschädigung beim Spritzvorgang ausgeschlossen wird.

Im Hinblick auf das elektronische Gerät wird die Aufgabe dadurch gelöst, dass das Stanzblechteil mindestens einen schutzschildartigen Bereich aufweist, unter welchem die elektronischen Bauteile angeordnet sind und dass die elektronischen Bauteile in Spritzdruckrichtung des erwärmten, thermoplastischen, isolierenden Materials hinter dem Stanzblechteil angeordnet sind.

Die Erfindung hat den Vorteil, dass das ohnehin zur elektrischen Kontaktierung und zur mechanischen Fixierung der elektronischen Bauteile notwendige Stanzblechteil, das auch als Leadframe bezeichnet wird, bei erfindungsgemäßer Ausbildung und Anordnung auch einen Schutz der elektronischen Bauteile gegen die fertigungsbedingten Belastungen sicherstellt.

Bei einer vorteilhaften Ausgestaltung ist dem mindestens einen schutzschildartigen Bereich mindestens eine mechanische Verstärkung aufgeprägt. Durch das Aufprägen einer mechanischen Struktur wird auf kostengünstige und wenig aufwendige Art eine erhöhte mechanische Festigkeit erzielt, was eine bessere Widerstandsfähigkeit der schutzschildartigen Bereiche gegen die mechanischen Belastungen beim Aufspritzen des thermoplastischen Materials zur Folge hat. Die Aufprägungen können zum Beispiel die Form eines Doppelkreuzes, einer Kuppel oder eines Kleeblatts aufweisen. Zudem kann die Form der Aufprägung der Form des von ihr überdeckten elektronischen Bauteils vorteilhaft angepasst werden.

Alternativ dazu ist dem mindestens einen schutzschildartigen Bereich die mechanische Verstärkung aufgeklebt, aufgeschweißt oder aufgelötet. Das hat den Vorteil, dass die mit dem schutzschildartigen Bereich verbundene mechanische Verstärkung eine besonders hohe mechanische Belastbarkeit des Schutzschildes bewirkt.

In einer Weiterbildung ist das Stanzblechteil mit den elektronischen Bauteilen derart verbunden, dass vom erwärmten Stanzblechteil sehr wenig thermische Energie auf die elektronischen Bauteile übertragen wird. Hierdurch wird sichergestellt, dass der größte Teil der von dem verspritzten Material übertragenen thermischen Energie vom unempfindlichen Stanzblechteil aufgenommen wird und die elektronischen Bauteile weitgehend vor der thermischen Belastung geschützt werden.

In einer weiteren Ausgestaltung ist der mindestens eine schutzschildartige Bereich des Stanzblechteils flächenartig ausgebildet und diese Fläche ist mindestens einem elektronischen Bauteil gegenüberliegend angeordnet. Mit der flächenartigen Ausgestaltung des Schutzschildes lassen sich die dahinter angeordneten elektronischen Bauteile besonders gut vor der Energie des verspritzten thermoplastischen Materials schützen.

Bei einer nächsten Ausgestaltung sind die zu schützenden elektronischen Bauteile zwischen dem Stanzblechteil und einem Gehäuseunterteil angeordnet. Das Gehäuseunterteil erfüllt hierbei die Funktion eines Auffangkörpers für das verspritzte thermoplastische, isolierende Material. Gleichzeitig dient das Gehäuseunterteil als mechanisch fester und gegen Umwelteinflüsse resistenter Abschluss des elektronischen Geräts zur Umgebung. Darüber hinaus kann das Gehäuseunterteil Mittel zur Anbindung des elektronischen Geräts an die das Gerät tragenden Komponenten aufweisen.

Bei einer Weiterbildung ist in dem Gehäuseunterteil mindestens eine kammerartige Ausformung ausgebildet. In die kammerartige Ausformung kann zum Beispiel der Sensor, ein Kondensator, ein Widerstand oder ein anderes elektronisches Bauteil eingebracht werden, bevor das elektronische Gerät umspritzt wird. Durch die kammerartige Ausformung wird ein kleines, definiertes Volumen geschaffen, dass mit dem thermoplastischen, isolierenden Material gefüllt wird.

Darüber hinaus ist es denkbar, dass das Gehäuseunterteil mindestens einen Kanal aufweist, der das gezielte Auffüllen der kammerartigen Ausformung in dem Gehäuseunterteil und/oder des gesamten Gehäuseunterteils mit thermoplastischem, isolierenden Material ermöglicht. Hierdurch wird es möglich das empfindliche in der kammerartigen Ausformung lokalisierte elektronische Bauteil vor der hohen thermischen und kinetischen Energie des thermoplastischen Materials zu schützen und es dennoch teilweise oder vollständig mit dem isolierenden Material zu umgeben.

Vorteilhaft ist es, wenn die schutzschildartigen Bereiche mindestens einen Durchbruch aufweisen, der eine gezielte Befüllung der kammerartigen Ausformung in dem Gehäuseunterteil und/oder des gesamten Gehäuseunterteils mit thermoplastischem, isolierenden Material ermöglicht. Der Durchbruch wird dabei derart in dem schutzschildartigen Bereich lokalisiert, dass alle Bestandteile des elektronischen Geräts optimal von dem thermoplastischen Material umschlossen werden, ohne das die von dem thermoplastischen Material mitgeführte hohe Energie zur Zerstörung der empfindlichen elektronischen Bauteile führt.

Bei einer Ausgestaltung berührt ein elastisches, schwingungsdämpfendes Material die zu schützenden elektronischen Bauteile (4) zumindest teilweise.
Neben der elektrischen Isolation der elektronischen Bauteile und dem Schutz der Bauteile vor Umwelteinflüssen, ist es sehr vorteilhaft, die Bauteile auch vor ungewollten Vibrationen zu schützen. Hierzu kann ohne oder in Ergänzung zu dem thermoplastischen, isolierenden Material ein elastisches, schwingungsdämpfendes Material in das Gehäuseunterteil eingesetzt werden. Natürlich kann auch ein einziges verspritztes Material alle genannten Eigenschaften in sich vereinigen.

Bei einer nächsten Ausgestaltung sind die Anschlussleiter der elektronischen Bauteile mit dem Stanzblechteil verschweißt, verklebt oder verlötet. Schweißen oder Löten sind einfache und kostengünstige Methoden zur elektrischen und mechanischen Verbindung elektronischer Bauteile mit Metallteilen, die großtechnisch leicht eingesetzt werden können.

Hierbei können die Anschlussleiter der elektronischen Bauteile S-förmig gebogen sein, wodurch die Bauteile zum einen nach der Anbindung an des Stanzblechteil sofort ihre erwünschte Lage einnehmen und zum anderen einfacher beim Anbinden zu handhaben sind.

Daneben können die Anschlussleiter der elektronischen Bauteile derartig gebogen sein, dass die elektronischen Bauteile in einem gewünschten Winkel zum Stanzblechteil stehen. Für einige Sensoren zum Beispiel ist es von Bedeutung, dass sie in einem vorgegebenen Winkel zu einem Bauteil, das ein Signal in dem Sensor erzeugt angeordnet sind. Wenn die Anschlussleiter von vornherein in vorteilhafter Weise gebogen sind, erübrigt sich eine nachträgliche Bearbeitung der mit dem Stanzblechteil verbundenen elektronischen Bauteile.

Bei einer nächsten vorteilhaften Weiterbildung weist das Stanzblechteil Verbindungselemente zur Kontaktierung anderer elektronischer Geräte auf. Hierdurch erübrigt sich die nachträgliche Montage eines Steckers. Besonders vorteilhaft ist es, wenn die Verbindungselemente als Flachkontakte ausgebildet sind, da Flachkontakte einen besonders guten und sicheren elektrischen Kontakt zu dem nächsten elektronischen Gerät gewährleisten.

Die Erfindung lässt zahlreiche Ausführungsformen zu. Eine davon soll anhand der in den Zeichnungen dargestellten Figuren erläutert werden. Diese zeigen in
- Fig. 1: eine Schnittdarstellung eines Sensorsystems mit zwei Sensorköpfen und dem erfindungsgemäßen Stanzblechteil,
- Fig. 2: eine Draufsicht auf ein erfindungsgemäßes Stanzblechteil,
- Fig. 3: eine seitliche Ansicht des erfindungsgemäßen Stanzblechteils mit den geschützten elektronischen Bauteilen,
- Fig. 4: eine perspektivische Ansicht des erfindungsgemäßen Stanzblechteils,
- Fig. 5: eine perspektivische Ansicht eines Gehäuseunterteils,
- Fig. 6: ein auf dem Gehäuseunterteil angebrachtes Stanzblechteil.

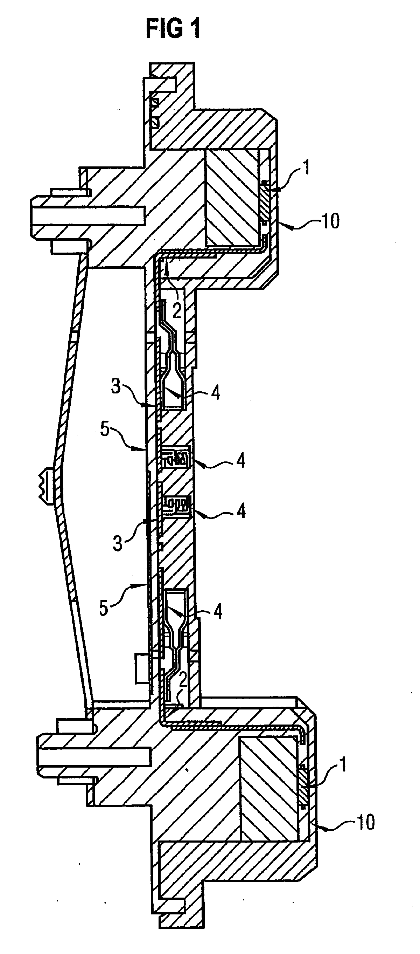

Fig. 1 zeigt ein Sensorsystem mit zwei Hall-Sensoren 1, einem Stanzblechteil 2, schutzschildartigen Bereichen 3 des Stanzblechteils 2 und elektronischen Bauteilen 4, die mit dem Stanzblechteil 2 verbunden sind. Zum Schutz vor Umwelteinflüssen sind die Sensorköpfe 1 mit einem abdeckenden Gehäuseunterteil 10 versehen. Mit Hilfe des Stanzblechteils 2 sind die Hall-Sensoren 1 mit den elektronischen Bauteilen 4 elektrisch verbunden. Am Stanzblechteil 2 sind alle elektronischen Bauteile 4 angeordnet, die in unmittelbarer Nähe zu den Hall-Sensoren 1 platziert werden müssen, wie zum Beispiel Entstörkondensatoren oder Vorverstärker. Das Stanzblechteil 2 ist als freitragende, metallische Struktur ausgebildet, die sowohl als Leiterbahn 7 verwendet wird als auch zur mechanischen Fixierung der elektronischen Bauteile 4 benötigt wird. Die elektronischen Bauteile 4 werden mit dem Stanzblechteil 2 durch Löten oder Schweißen verbunden. Das Stanzblechteil 2 weist schutzschildartige Bereiche 3 auf, in deren Schutzbereich die elektronischen Bauteile 4 platziert werden.

Die Herstellung des elektronischen Geräts erfolgt, indem das mit elektronischen Bauteilen 4 bestücktes Stanzblechteil 2 zum Schutz der elektronischen Bauteile 4 und der Leiterbahnenstruktur 7 vor Umwelteinflüsse in das Gehäuseunterteil 10 eingelegt und dann mit dem thermoplastischem Material 5 umspritzt wird, wodurch ein hermetischer Abschluss gegen die Umwelteinflüsse entsteht.

Das thermoplastische Material 5 wird mit relativ hohem Druck und mit hoher Temperatur direkt auf das Stanzblechteil 2 gespritzt. Da die elektronischen Bauteile 4 auf der dem Gehäuseunterteil 10 zugewandten Seite des Stanzblechteils 2 in das Gehäuseunterteil 10 eingelegt sind, verhindert die erfindungsgemäße Abdeckung der elektronischen Bauteile 4 durch die schutzschildartigen Bereiche 3 des Stanzblechteils 2 die Beschädigung der elektronischen Bauteile 4 nachhaltig.

Das thermoplastische Material 5 erreicht zunächst das Stanzblechteil 2 und deponiert hier seine kinetische Energie. Die Struktur des Stanzblechteils 2 ist mechanisch stabil genug, um den Belastungen standzuhalten. Auch ein großer Teil der vom thermoplastischen Material 5 mitgeführten thermischen Energie wird vom Stanzblechteil 2 abgefangen und somit ist ein effektiver Schutz der elektronischen Bauteile 4 vor druckbedingter und thermischer Zerstörung während der Kunststoffumspritzung gewährleistet.

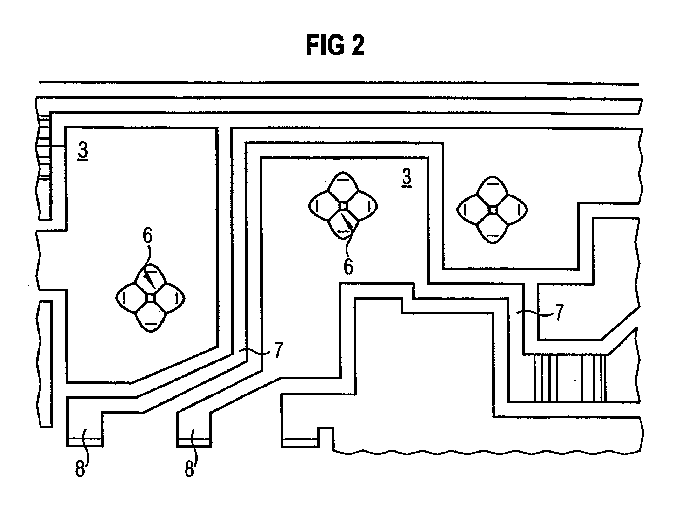

Fig. 2 zeigt eine Draufsicht auf ein erfindungsgemäßes Stanzblechteil 2. Dargestellt sind die schutzschildartigen Bereiche 3 des Stanzblechteils 2 und die freitragenden elektrischen Leiterbahnen 7, die zur elektrischen Verbindung der elektronischen Bauteile 4 genutzt werden. Den schutzschildartigen Bereichen 3 des Stanzblechteils 2 sind mechanische Verstärkungen 6 aufgeprägt, um den Druckbelastungen während des Spritzvorganges besser standhalten zu können. Diese Verstärkungen 6 können die Form eines Kuppeldaches, eines Doppelkreuzes oder eines Kleeblatts aufweisen. Es ist aber auch denkbar, dass mechanische Verstärkungen 6 aufgeklebt, aufgelötet oder aufgeschweißt werden.

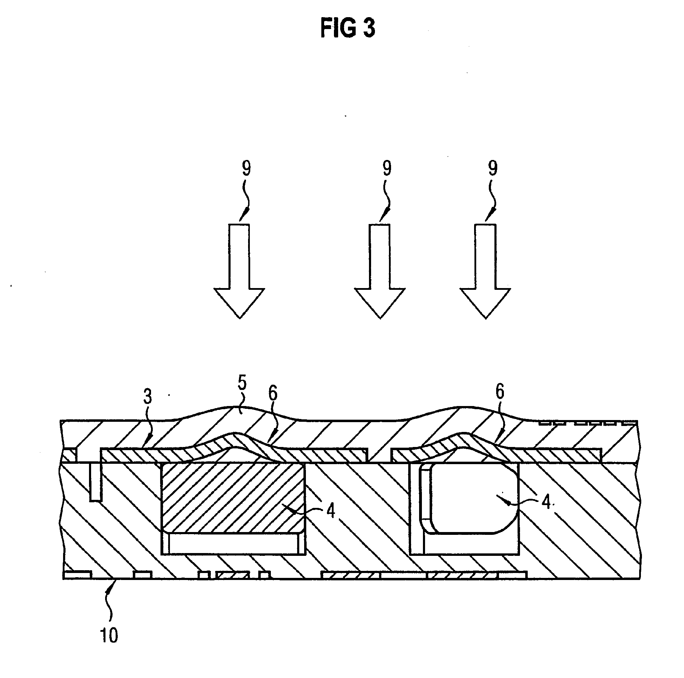

In Fig. 3 ist eine seitliche Ansicht des erfindungsgemäßen Stanzblechteils 2 mit den geschützten elektronischen Bauteilen 4 und dem Gehäuseunterteil 10 dargestellt. Zu sehen sind die schutzschildartigen Bereiche 3 des Stanzblechteils 2 mit den kuppelartigen Aufprägungen 6. Unter den schutzschildartigen Bereichen 3 des Stanzblechteils 2 sind elektronische Bauteile 4 angeordnet. Über den schutzschildartigen Bereichen 3 des Stanzblechteils 2 ist eine Schutzschicht angedeutet, die aus dem aufgespritzten thermoplastischen Material 5 besteht. Die Richtung aus der das thermoplastische Material 5 die spritzdruckbedingten Kräfte auf das Stanzblechteil 2 überträgt, ist durch die Vektoren 9 gekennzeichnet. Es ist deutlich erkennbar, dass die elektronischen Bauteile 4 durch die schutzschildartigen Bereiche 3 des Stanzblechteils 2 vor der von dem aufgespritzten thermoplastischen Material 5 übertragenen Energie geschützt werden.

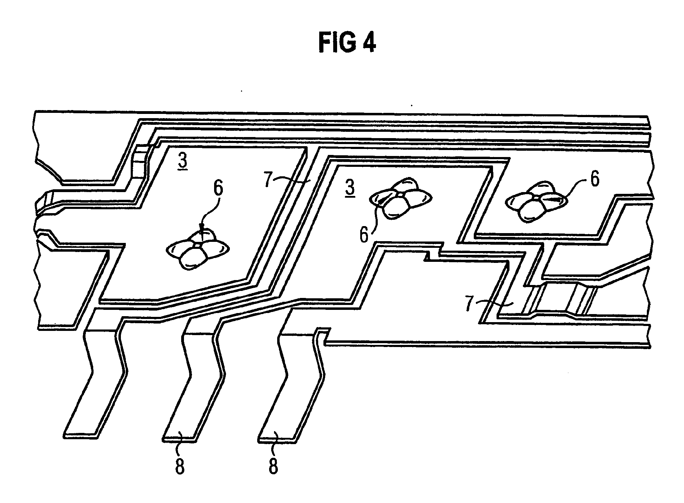

In Fig. 4 ist eine perspektivische Ansicht des erfindungsgemäßen Stanzblechteils 2 dargestellt. Gezeigt werden wiederum die schutzschildartigen Bereiche 3 des Stanzblechteils 2 sowie die freitragenden elektrischen Leiterbahnen 7. Die Enden der freitragenden elektrischen Leiterbahnen 7 können als Steckverbindungselemente 8 zu anderen elektronischen Baugruppen ausgebildet sein. Die Verbindungselemente 8 sind in diesem Ausführungsbeispiel als Flachkontakte ausgebildet.

Auf den schutzschildartigen Bereichen 3 des Stanzblechteils sind kleeblattförmige mechanische Verstärkungen 6 aufgeprägt, die eine erhöhte Spritzdruckresistenz der schutzschildartigen Bereiche 3 des Stanzblechteils 2 gewährleisten.

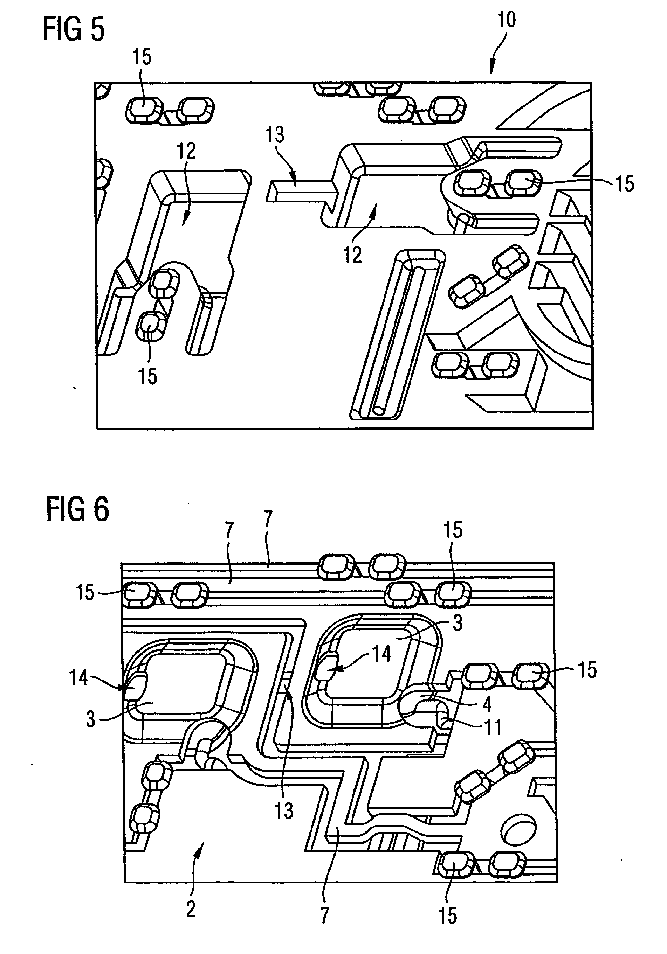

Figur 5 zeigt ein Gehäuseunterteil 10 mit kammerartigen Ausformungen 12. Die kammerartigen Ausformungen 12 dienen als Behausung für die mit dem Stanzblechteil 2 elektrisch und mechanisch verbundenen elektronischen Bauteilen 4. Zur kammerartigen Ausformung 12 führt ein Kanal 13. Der Kanal 13 ermöglicht die gezielten Auffüllung der kammerartigen Ausformung 12 mit thermoplastischem, isolierenden Material 5. Auf dem Gehäuseunterteil 10 aufgebrachte Befestigungspfosten 15 dienen zur Befestigung des Stanzblechteils 2 an dem Gehäuseunterteil 10. Ein an dem Gehäuseunterteil 10 befestigtes Stanzblechteil 2 wird in Figur 6 dargestellt.

In der Darstellung in Figur 6 wird das Gehäuseunterteil 10 fast vollständig vom Stanzblechteil 2 verdeckt. Zu erkennen sind die zwischen den Leiterbahnen 7 des Stanzblechteils 2 angeordneten Befestigungspfosten 15. Die Befestigungspfosten 15 bewirken einen festen und passgenauen Sitz des Stanzblechteils 2 auf dem Gehäuseunterteil 10.

Die schutzschildartigen Bereiche 3 des Stanzblechteils 2 weisen in diesem Ausführungsbeispiel Durchbrüche 14 auf. Mit Hilfe dieser Durchbrüche 14 kann die kammerartige Ausformung 12 gezielt mit thermoplastischem, isolierenden Material 5 aufgefüllt werden. Vorteilhafterweise wirken die Durchbrüche 14 mit den Kanälen 13 zusammen, so dass die elektronischen Bauteile 4 nicht direkt vom thermoplastischen, isolierenden Material 5 getroffen werden, sondern nach Abgabe der kinetischen und eines großen Teils der thermischen Energie des thermoplastischen Materials von diesem sanft umflossen werden.

Der schutzschildartige Bereich 3 ist in diesem Ausführungsbeispiel derartig gestaltet, dass die s-förmig gebogenen Anschlussleiter 11 des hier dargestellten elektronischen Bauteils 4 nicht vom schutzschildartigen Bereich 3 verdeckt werden. Anschlussleiter 11 elektronischer Bauteile 4 sind im allgemeinen wenig empfindlich gegen mechanische und thermische Belastungen. Daher können die Anschlussleiter 11 direkt mit dem thermoplastischen, isolierenden Material 5 bespritzen werden ohne dass befürchtet werden muss, dass ein elektronisches Bauteil 4 beschädigt wird. Ein wesentlicher Vorteil der erfindungsgemäßen Gestaltung des Stanzblechteils 4 ist es, dass empfindliche Bereiche elektronischer Bauteile 4 sehr effektiv geschützt werden können, während andere Bereiche der Schaltung direkt vom thermoplastischen isolierenden Material 5 getroffen werden können, ohne dass es zu einer Beschädigung der Schaltung kommt.

## Patentansprüche

1. Verfahren zur Herstellung eines elektronischen Geräts, wobei ein mit elektronischen Bauteilen bestücktes Stanzblechteil mit einem thermoplastischen, isolierenden Material zum Schutz vor Umwelteinflüssen umspritzt wird, **dadurch gekennzeichnet, dass** das erwärmte, thermoplastische, isolierende Material (5) so verspritzt wird, dass es zunächst das Stanzblechteil (2) erreicht, wodurch dort ein wesentlicher Teil seiner thermischen und kinetischen Energie deponiert wird und es anschließend die elektronischen Bauteile (4) umfließt.

2. Elektronisches Gerät bestehend aus auf einem Stanzblechteil angeordneten und durch dieses elektrisch miteinander verbundenen elektronischen Bauteilen, wobei das Stanzblechteil und die elektronischen Bauteile im Spritzgussverfahren mit einem thermoplastischen, isolierenden Material umspritzt sind, **dadurch gekennzeichnet, dass** das Stanzblechteil (2) mindestens einen schutzschildartigen Bereich (3) aufweist, unter welchem die elektronischen Bauteile angeordnet sind und dass die elektronischen Bauteile (4) in Spritzdruckrichtung (9) des erwärmten, thermoplastischen, isolierenden Materials (5) hinter dem Stanzblechteil (2) angeordnet sind.

3. Elektronisches Gerät nach Anspruch 2, **dadurch gekennzeichnet, dass** dem mindestens einen schutzschildartigen Bereich (3) mindestens eine mechanische Verstärkung (6) aufgeprägt ist.

4. Elektronisches Gerät nach Anspruch 2, **dadurch gekennzeichnet, dass** dem mindestens einen schutzschildartigen Bereich (3) die mechanische Verstärkung (6) aufgeklebt, aufgeschweißt oder aufgelötet ist.

5. Elektronisches Gerät nach einem der Ansprüche 3 oder 4, **dadurch gekennzeichnet, dass** die mechanische Verstärkung (6) die Form eines Doppelkreuzes oder einer Kuppel oder eines Kleeblatts hat.

6. Elektronisches Gerät nach mindestens einem der vorgenannten Ansprüche, **dadurch gekennzeichnet, dass** das Stanzblechteil (2) mit den elektronischen Bauteilen 4 derart verbunden ist, dass vom erwärmten Stanzblechteil (2) sehr wenig thermische Energie auf die elektronischen Bauteile (4) übertragen wird.

7. Elektronisches Gerät nach mindestens einem der vorgenannten Ansprüche, **dadurch gekennzeichnet, dass** der mindestens eine schutzschildartige Bereich (3) des Stanzblechteils (2) flächenartig ausgebildet ist und diese Fläche mindestens einem elektronischen Bauteil (4) gegenüberliegend angeordnet ist.

8. Elektronisches Gerät nach mindestens einem der vorgenannten Ansprüche, **dadurch gekennzeichnet, dass** das Stanzblechteil (2) mit den schutzschildartigen Bereichen (3) und den Leiterbahnen (7) als freitragende, metallische Struktur ausgebildet ist.

9. Elektronisches Gerät nach mindestens einem der vorgenannten Ansprüche, **dadurch gekennzeichnet, dass** die zu schützenden elektronischen Bauteile (4) zwischen dem Stanzblechteil (2) und einem Gehäuseunterteil (10) angeordnet sind.

10. Elektronisches Gerät nach mindestens einem der vorgenannten Ansprüche, **dadurch gekennzeichnet, dass** in dem Gehäuseunterteil (10) mindestens eine kammerartige Ausformung (12) ausgebildet ist.

11. Elektronisches Gerät nach Anspruch 10, **dadurch gekennzeichnet, dass** das Gehäuseunterteil (10) mindestens einen Kanal (13) aufweist, der das gezielte Auffüllen der kammerartigen Ausformung (12) in dem Gehäuseunterteil (10) mit thermoplastischem, isolierenden Material (5) ermöglicht.

12. Elektronisches Gerät nach mindestens einem der vorgenannten Ansprüche, **dadurch gekennzeichnet, dass** die schutzschildartigen Bereiche (3) mindestens einen Durchbruch (14) aufweisen, der eine gezielte Befüllung der kammerartigen Ausformung (12) in dem Gehäuseunterteil (10) und/oder des gesamten Gehäuseunterteils (10) mit thermoplastischem, isolierenden Material ermöglicht.

13. Elektronisches Gerät nach mindestens einem der vorgenannten Ansprüche, **dadurch gekennzeichnet, dass** ein elastisches, schwingungsdämpfendes Material die zu schützenden elektronischen Bauteile (4) zumindest teilweise berührt.

14. Elektronisches Gerät nach mindestens einem der vorgenannten Ansprüche, **dadurch gekennzeichnet, dass** die Anschlussleiter (11) der elektronischen Bauteile (4) mit dem Stanzblechteil (2) verschweißt, verklebt oder verlötet sind.

15. Elektronisches Gerät nach mindestens einem der vorgenannten Ansprüche, **dadurch gekennzeichnet, dass** die Anschlussleiter (11) der elektronischen Bauteile (4) S-förmig gebogen sind.

16. Elektronisches Gerät nach mindestens einem der vorgenannten Ansprüche, **dadurch gekennzeichnet, dass** die Anschlussleiter (11) der elektronischen Bauteile (4) derartig gebogen sind, dass die elektronischen Bauteile (4) in einem gewünschten Winkel zum Stanzblechteil (2) stehen.

17. Elektronisches Gerät nach mindestens einem der vorgenannten Ansprüche, **dadurch gekennzeichnet, dass** das Stanzblechteil (2) Verbindungselemente (8) zur Kontaktierung anderer elektronischer Geräte aufweist.

18. Elektronisches Gerät nach Anspruch 17, **dadurch gekennzeichnet, dass** die Verbindungselemente (8) als Flachkontakte ausgebildet sind.
